# EUROPÄISCHE PATENTSCHRIFT

(11) **EP 0 837 154 B1**
(45) Veröffentlichungstag und Bekanntmachung des Hinweises auf die Patenterteilung: **24.05.2000**
(21) Anmeldenummer: 97112819.4
(22) Anmeldetag: 25.07.1997
(51) Int. Cl.: C23C 14/56

(54) **Vakuumbeschichtungsanlage**
Vacuum coating apparatus
Appareillage de revêtement sous vide

(30) Priorität: 17.10.1996 DE 19642852
(43) Veröffentlichungstag der Anmeldung: 22.04.1998
(73) Patentinhaber: Leybold Systems GmbH, 63450 Hanau (DE)
(72) Erfinder: Patz, Ulrich, Dr., 63589 Linsengericht (DE); Ickes, Gerd, 63512 Hainburg (DE)

(56) Entgegenhaltungen:
- EP-A- 0 732 727
- WO-A-96/18755
- DE-A- 1 958 004

## Beschreibung

Die Erfindung betrifft eine Vakuumbehandlungsanlage zum Aufbringen dünner Schichten auf dreidimensionale, schalenförmige oder prismatische Substrate mit mehreren, von einer ortsfesten, kreiszylindrischen Vakuumkammerwand der im übrigen geschlossenen Vakuumkammer gehaltenen Behandlungsstationen und mit einem von der Vakuumkammerwand umschlossenen, die Substratkammern tragenden Innenzylinder mit in der Vakuumkammerwand vorgesehenen Öffnungen, mit denen die Substratkammern in Deckung bringbar sind und durch die die Behandlungsmittel auf die Substrate einwirken können.

Ein Nachteil bekannter Vorrichtungen liegt in einer aufwendigen Bauweise und oft auch darin, daß sie nur für ganz bestimmtes Beschichtungsgut, beispielsweise für flaches, scheibenförmiges Gut verwendbar sind. Das Aus- und Einschleusen des Beschichtungsgutes ergab oft schwierige Dichtungsprobleme, die durch aufwendige Schleusenkonstruktionen gelöst wurden.

Aus der DE-OS 22 41 634 ist eine Vakuumbeschichtungsanlage der eingangs genannten Art bekannt, bei der die Fördereinrichtung um eine gemeinsame Achse herum angeordnete und um diese schwenkbare topfförmige Rahmen für die Aufnahme des zu beschichtenden Gutes aufweist, wobei in einer Behandlungsposition, nämlich in der Ein- und Ausschleusposition, ein solcher Rahmen selbst Teil der Wand der Ein- und Austrittskammer bildet und eine bewegliche Ventilplatte zum Absperren einer Stirnseite des einen Teils der Ein- und Austrittskammer bildenden Rahmens vorgesehen ist. Bei dieser bekannten Vakuumbeschichtungsanlage ist das Ein- und Ausschleusen des zu beschichtenden Gutes konstruktiv einfach gelöst. Die Weiterbewegung des zu beschichtenden Gutes insbesondere in die Aufdampfposition ist jedoch kompliziert. Der das Gut enthaltende topfförmige Rahmen wird durch Weiterdrehen der Fördereinrichtung in eine Übergabeposition gebracht, aus der die einzelnen Substrate durch eine von unten her angreifende Hubvorrichtung aus dem topfförmigen Rahmen herausgehoben und nach oben in die eigentliche Aufdampfkammer bewegt werden. Hierdurch ergibt sich nicht nur ein erheblicher konstruktiver Aufwand, sondern auch ein komplizierter und zeitraubender Betriebsablauf.

Aus der DE 24 54 544 ist weiterhin eine Vakuumbeschichtungsanlage zum Aufdampfen dünner Schichten auf Substrate bekannt, mit einer Eintrittskammer, weiteren Kammern zur Behandlung bzw. Beschichtung der Substrate und mit einer Austrittskammer, sowie mit einer in einer evakuierbaren Hauptkammer angeordneten Fördereinrichtung zum Transport der Substrate durch die Kammern, wobei Abdichteinrichtungen zur zeitweisen Abdichtung zwischen den genannten Kammern und der Hauptkammer vorgesehen sind und bei der die Fördereinrichtung um eine gemeinsame Achse herum angeordnete und um diese schwenkbare Rahmen für die Aufnahme des zu beschichtenden Gutes aufweist, wobei in wenigstens zwei Behandlungspositionen, nämlich einer Ein- und Austrittsposition und einer Aufdampfposition, ein solcher Rahmen selbst Teil der Wand einer Behandlungskammer, nämlich der Ein- und Austrittskammer und einer Aufdampfkammer bildet, wobei in mindestens einer dieser Behandlungspositionen eine bewegliche Ventilplatte zum Absperren einer Stirnseite des einen Teils der die Behandlungskammer bildenden Rahmens vorgesehen ist.

Bekannt ist auch eine Vorrichtung zum Aufbringen von Schichten auf Trägern unter Vakuum (DE 28 48 480), insbesondere für das abwechselnde Aufbringen von Metallschichten und von Glimmpolymerisationsschichten auf Träger bei der Herstellung von elektrischen Schichtkondensatoren, welche zumindest zwei Vakuumkammern aufweist, die durch Vakuumschleusen voneinander getrennt sind und bei denen in der ersten Vakuumkammer im Betrieb ein kleinerer Restdruck besteht als in der zweiten Kammer oder in den übrigen Kammern, welche eine Transporteinrichtung besitzt, die die zu beschichtenden Träger durch je eine gesonderte Vakuumschleuse von der ersten Vakuumkammer in die zweite Vakuumkammer und wieder in die erste Vakuumkammer oder in eine dritte Vakuumkammer transportieren kann, welche in den Vakuumkammern Einrichtungen zum Aufbringen von Schichten auf die auf der Transporteinrichtung befindlichen Träger enthält und bei welcher die Vakuumschleusen jeweils mehrere Backen, die einer Oberfläche bzw. Oberflächen der Transporteinrichtung unmittelbar gegenüberliegen und zu dieser bzw. diesen nur einen schmalen Spalt freilassen, und jeweils zwischen zwei Backen ein Absaugrohr zur Absaugung des Restgases aufweisen, wobei die Transporteinrichtung nur in einer Richtung bewegbar ist und die in Bewegungsrichtung der Transporteinrichtung vor der ersten Vakuumkammer liegende Vakuumschleuse längere Diffusionswege aufweist als die in Bewegungsrichtung der Transporteinrichtung hinter der ersten Vakuumkammer liegende Vakuumschleuse.

Schließlich ist eine Vakuumbearbeitungsanlage für das Oberflächenbehandeln von Substraten oder Werkstücken bekannt (EP-A-0 555 764), die zylinderartig ausgebildet ist, wobei mindestens eine Aufnahmekammer bzw. ein Behältnis für die Aufnahme der zu bearbeitenden Substrate entlang des Mantels einer kreis- bzw. zylinderförmigen Verteilkammer angeordnet ist, mit peripher nach außen gerichteten Kammeröffnungen, welche in den jeweiligen Bearbeitungspositionen gegen die entsprechenden, im Zylindermantel angeordneten Bearbeitungsstationen gerichtet sind, um die Bearbeitungs- bzw. Prozeßkammern zu bilden, welche Aufnahmekammern bzw. Behältnisse oder der Zylindermantel um die Zylindermittelachse rotierbar angeordnet sind, damit die Aufnahmekammern bzw. Behältnisse relativ zum Zylindermantel bewegbar sind, um von einer Bearbeitungsstation zur nächsten bewegt zu werden, wobei an einem Teil oder allen Aufnahmekammern bzw. Behältnissen und/oder Bearbeitungsstationen pneumatisch oder hydraulisch aktivierbare Dichtungen vorgesehen sind, um beim Bearbeitungsprozeß die Bearbeitungs- bzw. Prozeßkammern dichtend abzutrennen.

Der vorliegenden Erfindung liegt die Aufgabe zugrunde, eine Anlage des in Frage stehenden Typs zu schaffen, die geeignet ist, dreidimensionale, schalenförmige oder prismatische Substrate so zu bearbeiten, daß während eines einzigen Arbeitstaktes gleichzeitig mehrere, über getrennte Förderer transportierte Substrate ein- bzw. ausgeschleust und bearbeitet werden können.

Erfindungsgemäß wird diese Aufgabe gelöst durch zwei Schleusenstationen, die einander diametral gegenüber liegend, tangential zur Außenwand der Vakuumkammer angeordnet sind, wobei jeder dieser beiden Schleusenstationen jeweils ein Substratförderer zugeordnet ist, der abwechselnd jeweils ein Substrat zur Schleusenkammer hin oder von der Schleusenkammer weg fördert, wobei das Ein- und Ausschleusen der jeweils im Schleusenbereich befindlichen Substrate in Abhängigkeit der Drehbewegung des Innenzylinders erfolgt und jeweils mit einer ersten Drehbewegung Substrate von den Schleusenstationen zu den Prozeßstationen hin und anschließend mit einer zweiten Drehbewegung die Substrate von den Prozeßstationen zu den Schleusenstationen zurück gefördert werden.

Die erfindungsgemäßen Einzelheiten und Merkmale sind in den anhängenden Patentansprüchen näher beschrieben und gekennzeichnet.

Die Erfindung läßt die verschiedensten Ausführungsmöglichkeiten zu; eine davon ist in der anhängenden Zeichnung rein schematisch näher dargestellt, die den Schnitt quer durch die Vakuumbehandlungsanlage und die Draufsicht auf die mit der Vakuumbehandlungsanlage zusammenwirkenden Substrattransporteinrichtungen zeigt.

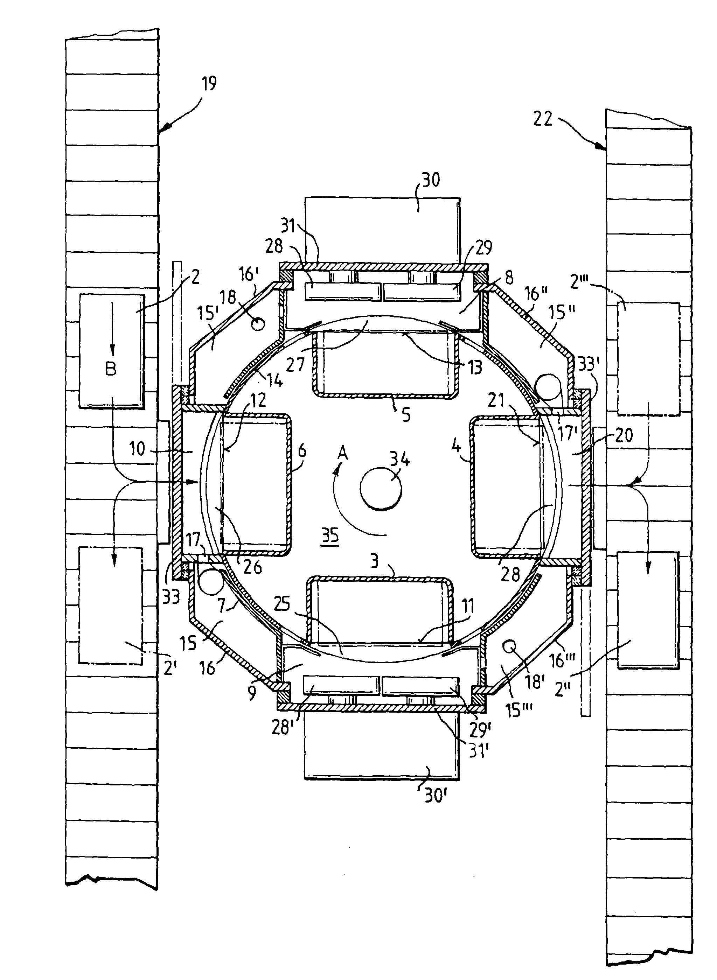

Die Vakuumbehandlungseinrichtung weist eine kreiszylindrische Vakuumkammer 7 auf, die mit mehreren, gleichmäßig auf ihrer Mantelfläche verteilt angeordneten, fensterförmigen Öffnungen 24 bis 27 versehen ist, wobei jeder Öffnung 24 bis 27 eine Behandlungsstation 8,9 oder Ein-/Ausschleusstation 10,20 zugeordnet ist, die jeweils aus einem kastenförmigen, zur jeweiligen Öffnung 24 bis 27 hin offenen Gehäuse besteht, dessen umlaufende Randpartie mit der zylindrischen Wand der Vakuumkammer 7 fest verbunden ist. Die zylindrische Vakuumkammer 7 umschließt einen Innenzylinder 14, der mit Öffnungen 11,12,13,21 versehen ist, die mit den zuvor erwähnten Öffnungen in der Vakuumkammer 7 korrespondieren und in die kastenförmige Substratkammern 3 bis 6 eingesetzt sind, die zusammen mit den Behandlungsstationen 8,9 bzw. den Ein-/Ausschleusstationen 10,20 in der in der Zeichnung dargestellten Stellung des Innenzylinders 14 jeweils allseitig geschlossene Behältnisse bilden. Die kreiszylindrische Vakuumkammerwand 7 ist von Außenwandteilen 16,16',... umgriffen, die jeweils fest mit den Wandteilen der Behandlungsstationen 8,9 bzw. den Ein-/Ausschleusstationen 10,20 verbunden sind und so zusammen mit der Kammerwand 7 Außenkammern 15,15'',... bilden. Zwei dieser Außenkammern 15,15',... sind über Bohrungen 17,17' mit den Innenwänden zweier Einschleusstationen 10,20 verbunden, wobei die Außenwände 16',16'' dieser beiden Außenkammern 15,15'' mit Vakuumpumpen fest verbunden sind, über die die Räume 3 bis 6 bzw. das Innere des Innenzylinders 14 evakuierbar sind. Darüber hinaus sind Gaseinlaßstutzen für Prozeßgase vorgesehen 18,18', so daß in den Behandlungsstationen 8,9 Beschichtungsprozesse durchgeführt werden können. Im Gehäuse der Behandlungsstationen 8,9 sind jeweils zwei Sputterkathoden 28,29,28',29' untergebracht, wobei die erforderlichen Stromversorgungen 30,30' an den Außenwänden 31,31' der Behandlungsstationen 8,9 befestigt sind. Zum Zwecke des Ein- bzw. Ausschleusens sind die Deckel 33,33' in die strichpunktiert eingezeichneten Stellungen verschiebbar. Sämtliche Kammern, nämlich die Behandlungsstationen 8,9, die Schleusenkammern 10,20, die Substratkammern 3 bis 6, die Außenkammern 15,15',.. und der Innenzylinder 14 sind von einer gemeinsamen Bodenplatte 35 und einer nicht dargestellten Deckplatte abgedeckt, so daß sich ein besonders einfacher Aufbau der Vorrichtung ergibt. Es ist klar, daß der Innenzylinder mit mindestens einer eigenen, kreisscheibenförmigen Platte 35 mit dem Motor 34 in drehfester Verbindung stehen muß, damit das aus dem Innenzylinder 14 und den Substratkammern 3 bis 6 bestehende Gebilde innerhalb der eigentlichen Vakuumkammer 7 rotieren kann.

Die dargestellte Vorrichtung zum Aufbringen dünner Schichten auf ein Substrat kann gleichzeitig über zwei Plattenbandförderer 19,22 mit Substraten beschickt werden, derart, daß jeweils gleichzeitig zwei Substrate eingeschleust, beschichtet oder ausgeschleust werden, wozu der Motor 34 den Innenzylinder 14 in Pfeilrichtung A (im Uhrzeigersinn) jeweils um eine viertel Umdrehung weiterdreht.

Bei der in der Zeichnung dargestellten Ausführungsform ist das Substrat 2 in Pfeilrichtung B bis kurz vor die Ein-/Ausschleusstation 10 vom Plattenförderer 19 bewegt worden; in dieser Phase des Fertigungsprozesses wird ein bereits in der Station 9 behandeltes Substrat 2' aus der Kammer 6 ausgeschleust und in die strichpunktiert eingezeichnete Position gefördert. Synchron mit diesem Vorgang ist das Substrat 2'' aus der Kammer 4 auf das Förderband 22 geschoben worden und das Substrat 2''' (strichpunktiert dargestellt) zum Einschleusen bereitgestellt. In der nächsten Phase werden die beiden bereitstehenden Substrate 2 und 2''' in die Kammern 6 bzw. 4 eingeschleust und anschließend die Kammern 6,4 mit Hilfe der Deckel 33 bzw. 33' verschlossen. In der nächsten Phase wird der Innenzylinder in Pfeilrichtung A um 90° weitergedreht, wobei die beiden Substrate 2,2''' vor die Sputterkathoden-Paare 28,29 bzw. 28',29' transportiert werden, wo sie anschließend beschichtet werden. Synchron mit dem Transport der Substrate 2,2''' vor die Kathodenstationen werden die zuvor in diesen Positionen befindlichen Substrate in die Ein-/Ausschleuspositionen, d.h. vor die Öffnungen 12 bzw. 21 gefördert usw.

Bei dem vorstehend geschilderten Produktionsablauf werden der Beschichtungsvorrichtung jeweils im sogenannten "H-track" gleichzeitig zwei Substrate 2,2''' zugeführt und zwei Substrate 2',2'' von der Vorrichtung abtransportiert, wobei das auf dem Transportband 19 zugeförderte Substrat auf dem parallelen, jedoch auf der anderen Seite der Vorrichtung angeordneten Transportband 22 abtransportiert wird (und umgekehrt).

Es ist jedoch ohne weiteres möglich, die auf dem einen Förderband 19 oder 22 angelieferten Substrate 2,2',... nach ihrer Behandlung in der Beschichtungsvorrichtung in sogenannten "Ω-track" über das gleiche Förderband wieder abzutransportieren. Dieses Verfahren hat den Vorteil, daß die Substrate auch zwei Behandlungsschritten unterworfen werden können, da nämlich beide Kathodenstationen 28,29 bzw. 28',29' durchlaufen werden, bis sie nach einer vollen Umdrehung des Innenzylinders 14 ausgeschleust werden können.

Schließlich ermöglicht die Vorrichtung den Betrieb im sogenannten "A-track". In diesen Fällen werden jeweils zwei Substrate 2,2',... gleichzeitig eingeschleust, bearbeitet und wieder ausgeschleust. Im Gegensatz zum "H-track" bleibt der Drehsinn des Innenzylinders 14 nicht gleich, sondern es wird die Drehrichtung nach jeweils einer 90°-Drehung geändert mit dem Ergebnis, daß das auf der einen Seite der Vorrichtung eingeschleuste Substrat nach seiner Behandlung auch auf der gleichen Seite wieder ausgeschleust und vom gleichen Plattenförderer wieder weitertransportiert wird.

### Bezugszeichenliste

- 2,2': Substrat
- 3: Substratkammer
- 4: Substratkammer
- 5: Substratkammer
- 6: Substratkammer
- 7: kreiszylindrische Vakuumkammerwand
- 8: Behandlungsstation
- 9: Behandlungsstation
- 10: Ein-/Ausschleusstation; Schleusenkammer
- 11: Öffnung
- 12: Öffnung
- 13: Öffnung
- 14: zylindrische Wand, Innenzylinder
- 15,15',...: Außenkammer
- 16,16',...: Außenwand
- 17,17',...: Bohrung
- 18,18': Gaseinlaßstutzen
- 19: Plattenbandförderer
- 20: Ein-/Ausschleusstation, Schleusenkammer
- 21: Öffnung
- 22: Plattenbandförderer
- 24: Öffnung
- 25: Öffnung
- 26: Öffnung
- 27: Öffnung
- 28,28': Sputterkathode
- 29,29': Sputterkathode
- 30,30': Stromversorgung
- 31,31': Außenwand
- 33,33': Deckel, Schleusenklappe
- 34: Motor
- 35: Platte

## Patentansprüche

1. Vakuumbehandlungsanlage zum Aufbringen dünner Schichten auf dreidimensionale, schalenförmige oder prismatische Substrate (2,2',...) mit mehreren, von der ortsfesten kreiszylindrischen Vakuumkammerwand (7) der im übrigen geschlossenen Vakuumkammer gehaltenen Behandlungs- (8,9) und Schleusenstationen (10,20) und mit einem von der Vakuumkammerwand (7) umschlossenen, drehbar gelagerten, die Substratkammern (3 bis 6) tragenden Innenwandzylinder (14), wobei in der Wand der Vakuumkammer (7) Öffnungen (25,26,27,28) vorgesehen sind, mit denen die Substratkammern (3 bis 6) in Deckung bringbar sind und durch die die Behandlungsmittel auf die Substrate (2,2',...) einwirken können und mit einer die Vakuumkammerwand (7) von außen umschließenden und die von der Vakuumkammerwand (7) sich radial nach außen zu erstreckenden und die Behandlungs- (8,9) und Schleusenstationen (10,20) miteinander verbindenden Außenwand (16,16',...), wobei zwei Schleusenstationen (10,20) einander diametral gegenüberliegend, tangential zur Außenwand der Vakuumkammer (7) angeordnet sind und jeder dieser beiden Schleusenstationen (10,20) jeweils ein Substratförderer (19 bzw. 22) zugeordnet ist, der abwechselnd jeweils ein Substrat zur Schleusenkammer (10,20) hin oder von der Schleusenkammer (10,20) weg fördert, wobei das Ein- und Ausschleusen der jeweils im Schleusenbereich befindlichen Substrate (2,2',...) in Abhängigkeit der Drehbewegung des Innenzylinders erfolgt und jeweils mit einer ersten Drehbewegung die Substrate (2,2''',...) von den Schleusenstationen (10 bzw. 20) zu den Prozeßstationen (8 bzw. 9) hin und anschließend mit einer zweiten Drehbewegung die Substrate (2,2''',...) von den Prozeßstationen (8 bzw. 9) zu den Schleusenstationen zurück fördert.

2. Vakuumbehandlungsanlage nach Anspruch 1, **dadurch gekennzeichnet**, daß auf dem Innenzylinder (14) gleichmäßig auf seinem Umfang verteilt vier Substratkammern (3 bis 6) gleicher Größe und Konfiguration angeordnet sind und für jeden Arbeitstakt der Innenzylinder (14) motorisch um eine viertel Umdrehung (= 90°) gedreht wird, wobei in Phasen zwischen den einzelnen Drehbewegungen der Transport der Substrate (2,2',...) von den Förderern (19 bzw. 22) in die Substratkammern (4,6 bzw. 3,5) bzw. von den Substratkammern zum Förderer erfolgt.

3. Vakuumbehandlungsanlage nach Anspruch 1, **dadurch gekennzeichnet,** daß auf dem Innenzylinder (14) gleichmäßig auf seinem Umfang verteilt vier Substratkammern (3 bis 6) gleicher Größe und gleicher Konfiguration angeordnet sind und der Innenzylinder (14) für jeden Arbeitstakt motorisch um eine viertel Umdrehung (= 90°) gedreht wird, wobei jeweils erst nach einer vollen Umdrehung des Innenzylinders 814) der Transport des vor Beginn der Drehbewegung in die erste Substratkammer eingeschleusten Substrats (2,...) wieder aus der ersten Substratkammer hinaus bewirkt wird und das Substrat von einem Förderer von der Anlage weg bewegt wird.

4. Vakuumbehandlungsanlage nach Anspruch 1, **dadurch gekennzeichnet**, daß auf dem Innenzylinder (14) gleichmäßig auf seinem Umfang verteilt vier Substratkammern gleicher Größe und gleicher Konfiguration angeordnet sind und für jeden Arbeitstakt der Innenzylinder (14) motorisch um eine viertel Umdrehung ( =90°) gedreht wird, wobei jeweils nach einer halben Umdrehung ( =180°) das vor Beginn der Drehbewegung vom ersten Förderer (19) aus in die Substratkammer (3,4,5,6) eingeschleuste Substrat (2,2',...) über eine auf der der Einschleusstation gegenüber liegenden Seite der Vakuumkammer angeordnete Schleusenstation (20) ausgeschleust und vom zweiten Förderer (22) von der Anlage weg transportiert wird.

5. Vakuumbehandlungsanlage nach Anspruch 1, **dadurch gekennzeichnet,** daß auf dem Innenzylinder (14) gleichmäßig auf seinem Umfang verteilt vier Substratkammern gleicher Größe und gleicher Konfiguration angeordnet sind und für jeden Arbeitstakt der Innenzylinder (14) motorisch um eine viertel Umdrehung ( =90°) gedreht wird, wobei jeweils das vom ersten Förderer (19) aus in die Substratkammer (6) eingeschleuste Substrat (2) im ersten Arbeitstakt in die Behandlungsstation (8) und im zweiten Arbeitstakt von dieser Behandlungsstation (8) aus in entgegengesetzter Drehrichtung zur Schleusenstation (10) zurück transportiert und auf dem ersten Förderer (19) abgelegt wird, wobei im ersten Arbeitstakt zusätzlich vom zweiten Förderer (22) aus ein zweites Substrat (2') in die gegenüberliegende Substratkammer (4) eingeschleust und anschließend in die zweite Behandlungsstation (9) und von dieser aus im zweiten Arbeitstakt zurück zur Substratkammer (4) und auf den zweiten Förderer (22) transportiert wird.

## Claims

1. Vacuum treatment installation for applying thin layers onto three-dimensional, shell-shaped or prismatic substrates (2, 2', ...), having a plurality of treatment stations (8, 9) and lock stations (10, 20) held by the stationary, circular-cylindrical vacuum chamber wall (7) of the otherwise closed vacuum chamber and having a rotatably mounted inner wall cylinder (14), which is enclosed by the vacuum chamber wall (7) and carries the substrate chambers (3 to 6), wherein in the wall of the vacuum chamber (7) openings (25, 26, 27, 28) are provided, with which the substrate chambers (3 to 6) may be brought to overlap and through which the treatment media may act upon the substrates (2, 2', ...), and having an outer wall (16, 16', ...), which externally encloses the vacuum chamber wall (7) and extends radially outwards from the vacuum chamber wall (7) and connects the treatment stations (8, 9) and lock stations (10, 20) to one another, wherein two lock stations (10, 20) are disposed diametrically opposite one another and tangentially relative to the outer wall of the vacuum chamber (7) and associated with each of said two lock stations (10, 20) there is in each case a substrate conveyor (19 or 22), which alternately conveys in each case one substrate towards the lock chamber (10, 20) or away from the lock chamber (10, 20), wherein the inward and outward transfer of the substrates (2, 2', ...) situated in each case in the lock region is effected in dependence upon the rotation of the inner cylinder and, in each case, with a first rotation the substrates (2, 2''', ...) are conveyed from the lock stations (10 and 20) to the processing stations (8 and 9) and then with a second rotation the substrates (2, 2''', ...) are conveyed from the processing stations (8 and 9) back to the lock stations.

2. Vacuum treatment installation according to claim 1, **characterized in** that four substrate chambers (3 to 6) of identical size and configuration are disposed so as to be uniformly distributed over the periphery of the inner cylinder (14) and for each work cycle the inner cylinder (14) is motor-rotated through a quarter revolution (= 90°), wherein during phases between the individual rotations the transport of the substrates (2, 2', ...) from the conveyors (19 and 22) into the substrate chambers (4, 6 and 3, 5) and from the substrate chambers to the conveyor is effected.

3. Vacuum treatment installation according to claim 1, **characterized in** that four substrate chambers (3 to 6) of identical size and identical configuration are disposed so as to be uniformly distributed over the periphery of the inner cylinder (14) and for each work cycle the inner cylinder (14) is motor-rotated through a quarter revolution (= 90°), wherein in each case it is only after one complete revolution of the inner cylinder 814) that the transport of the substrate (2, ...), which was transferred into the first substrate chamber before the start of the rotation, back out of the first substrate chamber is effected and the substrate is moved away from the installation by a conveyor.

4. Vacuum treatment installation according to claim 1, **characterized in** that four substrate chambers of identical size and identical configuration are disposed so as to be uniformly distributed over the periphery of the inner cylinder (14) and for each work cycle the inner cylinder (14) is motor-rotated through a quarter revolution (= 90°), wherein in each case after a half revolution (= 180°) the substrate (2, 2', ...), which was transferred from the first conveyor (19) into the substrate chamber (3, 4, 5, 6) before the start of the rotation, is transferred out via a lock station (20) disposed at the opposite side of the vacuum chamber to the inward transfer station and is carried away from the installation by the second conveyor (22).

5. Vacuum treatment installation according to claim 1, **characterized in** that four substrate chambers of identical size and identical configuration are disposed so as to be uniformly distributed over the periphery of the inner cylinder (14) and for each work cycle the inner cylinder (14) is motor-rotated through a quarter revolution (= 90°), wherein in each case the substrate (2), which was transferred from the first conveyor (19) into the substrate chamber (6), during the first work cycle is conveyed into the treatment station (8) and during the second work cycle is conveyed from said treatment station (8) in the opposite direction of rotation back to the lock station (10) and deposited on the first conveyor (19), wherein during the first work cycle a second substrate (2') is additionally transferred from the second conveyor (22) into the opposite substrate chamber (4) and then is conveyed into the second treatment station (9) and from the latter during the second work cycle back to the substrate chamber (4) and onto the second conveyor (22).

## Revendications

1. Installation de traitement sous vide pour l'application de couches minces sur des substrats tridimensionnels (2, 2', ...) en forme de coque ou en forme de prisme, comprenant plusieurs stations de traitement (8, 9) et plusieurs stations de sas (10, 20) maintenues par la paroi cylindrique stationnaire (7) de la chambre à vide, par ailleurs fermée, et comprenant un cylindre de paroi intérieur (14) entouré par la paroi (7) de la chambre à vide, monté en rotation, et portant les chambres à substrat (3 à 6), et des ouvertures (25, 26, 27, 28) étant prévues dans la paroi (7) de la chambre à vide, de sorte que les chambres à substrat (3 à 6) sont susceptibles d'être amenées en coïncidence avec les ouvertures, et les produits de traitement peuvent agir sur les substrats (2, 2', ...) à travers lesdites ouvertures, et comprenant une paroi extérieure (16, 16', ...) qui entoure la paroi (7) de la chambre à vide depuis l'extérieur et s'étend radialement vers l'extérieur depuis la paroi (7) de la chambre à vide et relie les unes aux autres les stations de traitement (8, 9) et les stations de sas (10, 20), deux stations de sas (10,20) qui sont diamétralement opposées étant agencées tangentiellement vis-à-vis de la paroi extérieure (7) de la chambre à vide, et à chacune de ces deux stations de sas (10, 20) est associé un convoyeur à substrat respectif (19 ; 22) lesquels transportent en alternance un substrat vers la chambre de sas (10, 20), ou bien en éloignement de la chambre de sas (10, 20), l'entrée et la sortie dans les sas des substrats (2, 2', ...) qui se trouvent respectivement dans la région des sas ayant lieu en fonction du mouvement de rotation du cylindre intérieur, les substrats (2, 2"', ...) étant amenés respectivement par un premier mouvement rotatif depuis les stations de sas (10 ; 20) vers les stations de traitement (8 ; 9), et les substrats (2, 2"', ...) étant amenés respectivement par un deuxième mouvement rotatif en retour depuis les stations de traitement (8, ; 9) vers les stations de sas.

2. Installation de traitement sous vide selon la revendication 1, caractérisée en ce que sur le cylindre intérieur (14) sont agencées quatre chambres à substrat (3 à 6) de même taille et de même configuration, réparties régulièrement sur la périphérie de celui-ci, et en ce que pour chaque cadence de fonctionnement le cylindre intérieur (14) est tourné par un moteur sur un quart de tour (= 90°), et le transport des substrats (2, 2', ...) depuis les convoyeurs (19 ; 22) jusque dans les chambres à substrat (4, 6 ; 3, 5), ou respectivement depuis les chambres à substrat vers les convoyeurs, a lieu dans les phases entre les mouvements rotatifs individuels.

3. Installation de traitement sous vide selon la revendication 1, caractérisée en ce que sur le cylindre intérieur (14) sont agencées quatre chambres à substrat (3 à 6) de même taille et de même configuration, réparties régulièrement sur la périphérie de celui-ci, et en ce que pour chaque cadence de fonctionnement le cylindre intérieur (14) est tourné par un moteur sur un quart de tour (= 90°), et ce n'est qu'après une rotation complète du cylindre intérieur (14) que se produit le transport du substrat (2, ...), introduit avant le commencement du mouvement de rotation dans la première chambre à substrat, à nouveau hors de cette première chambre à substrat, et le substrat est déplacé par un convoyeur en éloignement de l'installation.

4. Installation de traitement sous vide selon la revendication 1, caractérisée en ce que sur le cylindre intérieur (14) sont agencées quatre chambres à substrat de même taille et de même configuration, réparties régulièrement sur la périphérie de celui-ci, et en ce que pour chaque cadence de fonctionnement le cylindre intérieur (14) est tourné par un moteur sur un quart de tour (= 90°), et après chaque demi-rotation (= 180°), le substrat (2, 2', ...) qui a été introduit avant le commencement du mouvement de rotation par le premier convoyeur (19) jusque dans la chambre à substrat (3, 4, 5, 6) est sorti via une station de sas (20) agencée du côté opposé de la chambre à vide par rapport à la station d'entrée, et le substrat est déplacé par un deuxième convoyeur (22) en éloignement de l'installation.

5. Installation de traitement sous vide selon la revendication 1, caractérisée en ce que sur le cylindre intérieur (14) sont agencées quatre chambres à substrat de même taille et de même configuration, réparties régulièrement sur la périphérie de celui-ci, et en ce que pour chaque cadence de fonctionnement le cylindre intérieur (14) est tourné par un moteur sur un quart de tour (= 90°), et le substrat (2) qui a été introduit par le premier convoyeur (19) dans la chambre à substrat (6) est transporté jusque dans la station de traitement (8) pendant la première cadence de fonctionnement, et est transporté en retour dans la direction opposée depuis cette station de traitement (8) vers la station de sas (10) pendant la deuxième cadence de fonctionnement, et le substrat est déposé sur le premier convoyeur (19), et pendant la première cadence de fonctionnement, un deuxième substrat (2') est introduit additionnellement par le deuxième convoyeur (22) jusque dans la chambre à substrat opposée (4), et ce substrat est ensuite transporté dans la deuxième station de traitement (9), et depuis celle-ci en retour vers la chambre à substrat (4) et sur le deuxième convoyeur (22) pendant la deuxième cadence de fonctionnement.
